# EUROPÄISCHE PATENTSCHRIFT

(11) **EP 0 535 541 B1**
(45) Veröffentlichungstag und Bekanntmachung des Hinweises auf die Patenterteilung: **13.03.1996**
(21) Anmeldenummer: 92116390.3
(22) Anmeldetag: 24.09.1992
(51) Int. Cl.: H01L 21/82

(54) **Verfahren zur Herstellung einer Grabenstruktur in einem Substrat**
Method of fabricating a groove structure in a substrate
Procédé de fabrication d'une structure de fossés dans un substrat

(30) Priorität: 02.10.1991 DE 4132836
(43) Veröffentlichungstag der Anmeldung: 07.04.1993
(73) Patentinhaber: SIEMENS AKTIENGESELLSCHAFT, D-80333 München (DE)
(72) Erfinder: Grewal, Virinder, Dr., Fishkill, N.Y. 12524 (US); Schwarzl, Siegfried, Dr., W-8011 Neubiberg (DE)

(56) Entgegenhaltungen:
- EP-A- 0 201 706
- EP-A- 0 333 426
- DE-A- 3 841 588
- US-A- 5 013 679
- US-A- 5 047 815
- PATENT ABSTRACTS OF JAPAN vol. 14, no. 70 (E-886)(4013) 8. Februar 1990 ; & JP-A-12 87 956
- PATENT ABSTRACTS OF JAPAN vol. 14, no. 308 (E-947)(4251) 3. Juli 1990 ; & JP-A-21 00 357

## Beschreibung

Im Rahmen der fortschreitenden Miniaturisierung von integrierten Schaltungen werden verstärkt Grabenstrukturen in Siliziumsubstraten zur Vergrößerung der nutzbaren Oberfläche eingesetzt. Insbesondere in DRAM-Speicherschaltungen werden Grabenstrukturen zur Realisierung von Speicherkondensatoren oder zur Aufnahme von Transistoren eingesetzt. Für die weitere Prozeßführung ist es wichtig, daß diese Grabenstrukturen wohldefinierte Kanten an der Oberfläche des Substrats aufweisen. Insbesondere zur Herstellung von Kontakten zwischen einem in der Grabenstruktur angeordneten Speicherkondensator und einem Auswahltransistor oder zur Herstellung von Transistoren in der Grabenstruktur sind an der Oberfläche des Substrats definierte Ausgangsstrukturen erforderlich.

Zur Herstellung von Grabenstrukturen sind Grabenätzprozesse bekannt (s. H. Uchida et al, Proc. of the Symp. on Dry Process J. Electrochem. Soc. Proc. Vol. 88-7, 55 (1988); M. Engelhardt Proc. 15th Annual Tegal, Plasma Seminar, 53 (1989); V. Grewal et al, 9th International Symposium on Plasma Chemistry Pugnochiuso, Italy, 1989, s. 585-ff), bei denen als Ätzmaske Oxidschichten verwendet werden. Zur Herstellung von Grabenstrukturen mit senkrechten und glatten Grabenwänden werden die Grabenätzprozesse so geführt, daß sich an entstehenden Seitenwänden der Grabenstrukturen während der Grabenätzung Passivierungsschichten bilden. Diese Passivierungsschichten weisen eine oxidartige Zusammensetzung auf.

Nach der Grabenätzung werden die Passivierungsschichten mit einer Oxidätze entfernt. Die Oxidätze greift auch die Ätzmaske an. Die Ätzmaske wird z. T. abgeätzt und am Grabenhals zurückversetzt. Bei weiteren Ätzprozessen z. B. zur Vertiefung des Grabens werden daher die Grabenwände im Bereich der Siliziumoberfläche angegriffen. Da die Form der Ätzmaske am Grabenhals verändert wurde, erfolgt ein geänderter Ätzangriff im oberen Bereich des Grabens. Auf diese Weise werden die Grabenwände im oberen Bereich des Grabens nicht mehr senkrecht sein. Dies führt zu Problemen bei der weiteren Prozeßführung.

Der Erfindung liegt das Problem zugrunde, ein Verfahren zur Herstellung einer Grabenstruktur in einem Substrat anzugeben, mit dem Grabenstrukturen mit einer definierten Geometrie im Bereich der Substratoberfläche herstellbar sind. Insbesondere soll das Verfahren geeignet sein, Grabenstrukturen zu erzeugen, die im oberen Bereich bis in eine definierte Tiefe mit Spacern (Flankenbedeckungen) belegt sind.

Das Problem wird erfindungsgemäß gelöst durch ein Verfahren nach Anspruch 1.

Durch die Herstellung der ersten Si₃N₄-Spacer (Flankenbedeckungen) an den senkrechten Flanken der Grabenmaske vor der ersten Grabenätzung sind die senkrechten Flanken der Grabenmaske gegen einen Ätzangriff bei der Entfernung der oxidartigen Passivierungsschichten nach der ersten Grabenätzung geschützt. An den Seitenwänden der entstehenden Grabenstruktur werden nach der ersten Grabenätzung zweite Si₃N₄-Spacer gebildet. Diese schützen die Seitenwände der Grabenstruktur im oberen Bereich, der durch die erste Grabenätzung hergestellt wurde, vor einem Ätzangriff bei der Entfernung von bei der zweiten Grabenätzung gebildeten Passivierungsschichten oder vor der Oxidation bei der Bildung einer SiO₂-Schicht auf der Oberfläche der Grabenstruktur. Auf diese Weise wird eine Grabenstruktur hergestellt, die im oberen Bereich, d. h. in dem Bereich der durch die erste Grabenätzung hergestellt wird, eine definierte Geometrie aufweist. Die zweiten Si₃N₄-Spacer bedecken die Grabenstruktur in dem bei der ersten Grabenätzung hergestellten Bereich. Daher wird die Tiefe der Grabenstruktur, in der die Seitenwände der Grabenstruktur mit dem zweiten Si₃N₄-Spacer belegt sind, über die erste Tiefe der ersten Grabenätzung eingestellt. Die Ausdehnung der zweiten Si₃N₄-Spacer sind daher über die erste Tiefe der ersten Grabenätzung reproduzierbar einstellbar.

Es liegt im Rahmen der Erfindung, die Erzeugung der ersten Si₃N₄-Spacer und die erste Grabenätzung sowie die Erzeugung der zweiten Si₃N₄-Spacer und die zweite Grabenätzung jeweils in einem anisotropen Ätzprozeß durchzuführen. Dadurch werden Prozeßschritte eingespart.

Es ist besonders vorteilhaft, vor der anisotropen Grabenätzung einen Prozeßschritt unter Verwendung von Dummyscheiben zur Reinigung der Reaktionskammer durchzuführen. Dadurch werden Kontaminationen der Grabenstruktur vermieden.

Zur Kammerreinigung werden die Plasmaparameter so gewählt, daß ein Anätzen der Dummyscheiben nicht stattfinden kann, die Kammerwände jedoch gereinigt werden.

Die Dummyscheiben sind SiO₂-beschichtete Siliziumscheiben oder Al₂O₃-Scheiben, die mehrmals verwendet werden können.

Dieser Reinigungsschritt wird vor jeder Grabenätzung vorgenommen, so daß jede Prozeßscheibe konstante Kammerbedingungen sieht.

Für die Kammerreinigung werden z. B. folgende Parameter verwendet:
NF₃-Fluß 50 bis 80 sccm
Kammerdruck 100 bis 200 mTorr (13 bis 27 Pa)
R. F. Leistung 100 bis 300 Watt
D. C. Bias 10 Volt
magnetische Flußdichte 60 bis 100 G (60 x 10⁻⁴ bis 100 x 10⁻⁴ T) Ätzzeit ca. 1 Minute

Es liegt insbesondere im Rahmen der Erfindung, nach der zweiten Grabenätzung bei der zweiten Grabenätzung entstandene Passivierungsschichten selektiv zu Si₃N₄ und Silizium zu entfernen. Anschließend wird an der freiliegenden Siliziumoberfläche der Grabenstruktur, d. h. im Bereich der zweiten Grabenätzung, eine SiO₂-Schicht gebildet. Wenn die SiO₂-Schicht durch thermische Oxidation der Oberfläche hergestellt wird, bildet sich an der Grenzlinie zu den zweiten Si₃N₄-Spacer ein Vogelschnabel aus. Dadurch ist die Verwendung des erfindungsgemäßen Verfahrens leicht nachweisbar.

Die weitere Ausgestaltung der Erfindung geht aus den übrigen Ansprüchen hervor.

Im folgenden wird die Erfindung anhand eines Ausführungsbeispiels und der Figuren näher erläutert.
- Fig. 1: zeigt ein Siliziumsubstrat mit einer Grabenmaske, die mit einer Si₃N₄-Schicht bedeckt ist.
- Fig. 2: zeigt das Siliziumsubstrat nach der ersten Grabenätzung.
- Fig. 3: zeigt das Siliziumsubstrat nach Abscheidung der zweiten Si₃N₄-Schicht.
- Fig. 4: zeigt das Siliziumsubstrat nach der zweiten Grabenätzung.

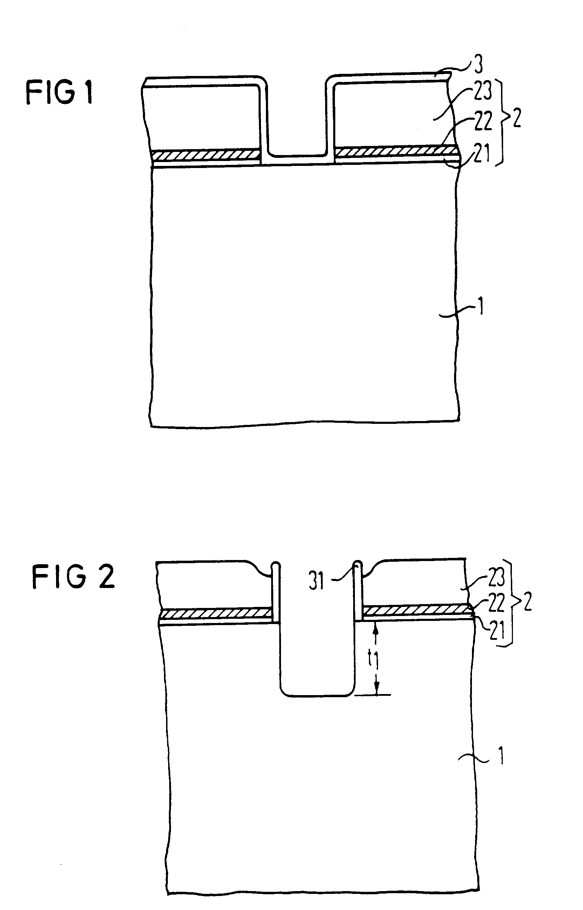

Auf einem Substrat 1 aus einkritallinem Silizium wird eine Grabenmaske 2 hergestellt (s. Fig. 1). Die Grabenmaske 2 umfaßt eine dünne SiO₂-Schicht 21, die auf der Oberfläche des Substrats 1 angeordnet ist. Die dünne SiO₂-Schicht 21 weist eine Dicke von z. B. 20 nm auf. Auf der dünnen SiO₂-Schicht 21 ist eine Si₃N₄-Schicht 22 in einer Dicke von z. B. 40 nm angeordnet. Auf der Si₃N₄-Schicht 22 ist eine SiO₂-Schicht 23 angeordnet. Die SiO₂-Schicht 23 wird durch CVD-Abscheidung nach thermischer Zersetzung von Si(OC₂H₅)₄ in dem sogenannten TEOS-Verfahren hergestellt. Die SiO₂-Schicht 23 wird in einer Dicke von z. B. 400 bis 1000 nm, vorzugsweise 600 nm, hergestellt. Die Grabenmaske 2 definiert den Bereich für die Grabenstruktur an der Oberfläche des Substrats 1 durch gemeinsame senkrechte Flanken der dünnen SiO₂-Schicht 21, der Si₃N₄-Schicht 22 und der SiO₂-Schicht 23.

Auf das Substrat 1 mit der Grabenmaske 2 wird ganzflächig eine erste Si₃N₄-Schicht abgeschieden. Die erste Si₃N₄-Schicht 3 weist eine Dicke von z. B. 20 bis 100 nm, vorzugsweise 20 bis 40 nm, auf. Die erste Si₃N₄-Schicht 3 bedeckt die Grabenmaske 2 sowohl an der Oberfläche der SiO₂-Schicht 23 als auch an den senkrechten Flanken. Des weiteren bedeckt die erste Si₃N₄-Schicht 3 die freiliegende Oberfläche des Substrats 1.

In einem anisotropen Ätzprozeß wird die Oberfläche der SiO₂-Schicht 23 und des Substrats 1 freigelegt. Dabei bilden sich erste Si₃N₄-Spacer 31 aus der ersten Si₃N₄-Schicht 3. Der anisotrope Ätzprozeß wird fortgesetzt, wobei eine erste Grabenätzung in das Substrat 1 erfolgt. Die Grabenmaske 2 wird durch den anisotropen Ätzprozeß nicht angegriffen. In dem ersten Grabenätzprozeß entstehen senkrechte Wände. An den senkrechten Wänden kommt es zur Abscheidung von Passivierungsschichten.

Diese sind oxidartig und werden selektiv zu Si₃N₄ und Silizium entfernt. Die Passivierungschichten werden z. B. durch HF-Dampf (Excalibur) oder naßchemisch entfernt. Zur naßchemischen Entfernung ist jedes Ätzmittel geeignet, das SiO₂ angreift, aber Si₃N₄ und Silizium nicht angreift. Dabei werden etwa 100 bis 150 nm von der Schichtdicke der SiO₂-Schicht 23 abgeätzt. Die ersten Si₃N₄-Spacer 31 werden nicht angegriffen (s. Fig. 2). Die erste Grabenätzung erfolgt in eine Tiefe t₁ von z. B. 2 µm.

Als anisotroper Prozeß ist der folgende Prozeß besonders geeignet:
HBr-Fluß 10 bis 60 sccm
NF₃-Fluß 2 bis 8 sccm
He-Fluß 5 bis 40 sccm
O₂-Fluß 0,5 bis 3 sccm
Kammerdruck 100 mTorr (13 Pa)
magnetische Flußdichte 70 bis 120 G (70 x 10⁴ bis 120 x 10⁴ T) RF-Leistung 400 bis 600 Watt
   Die Ätzzeit ist von der gewünschten Grabentiefe abhängig.

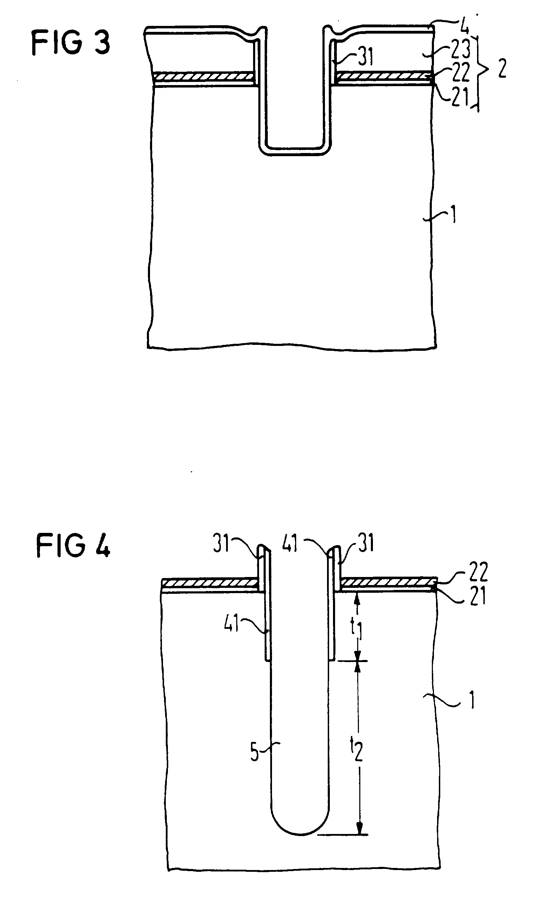

Nach einem Reinigungsschritt wird ganzflächig eine zweite Si₃N₄-Schicht 4 abgeschieden. Die zweite Si₃N₄-Schicht 4 wird in einer Dicke von z. B. 20 bis 100 nm, vorzugsweise 20 bis 40 nm abgeschieden. Die zweite Si₃N₄-Schicht bedeckt die Oberfläche der SiO₂-Schicht 23, der ersten Si₃N₄-Spacer 31 und die im Bereich der ersten Grabenätzung freiliegende Oberfläche des Substrats 1 vollständig (s. Fig. 3).

In einem weiteren anisotropen Ätzprozeß wird die zweite Si₃N₄-Schicht 4 im Bereich der Oberfläche der SiO₂-Schicht 23 und der Oberfläche des Bodens der ersten Grabenätzung entfernt. Dabei entstehen zweite Si₃N₄-Spacer 41 (s. Fig. 4). Die senkrechten Seitenwände, die bei der ersten Grabenätzung entstanden sind, werden von den zweiten Si₃N₄-Spacern 41 vollständig bedeckt. Der anisotrope Ätzprozeß wird fortgesetzt, so daß eine zweite Grabenätzung in das Substrat 1 hinein erfolgt. Bei der zweiten Grabenätzung entstehen wiederum senkrechte Seitenwände. An diesen senkrechten Seitenwänden werden bei der zweiten Grabenätzung Passivierungsschichten abgeschieden. Die zweite Grabenätzung wird bis in eine zweite Tiefe t₂ von z. B. 5 µm geätzt. Dadurch wird eine Grabenstruktur 5 fertiggestellt, die von der Oberfläche des Substrats 1 bis zum Grabenboden eine Tiefe entsprechend der Summe der ersten Tiefe t₁ und der zweiten Tiefe t₂ t₁ + t₂ aufweist. Die Passivierungsschichten, die bei der zweiten Grabenätzung abgeschieden werden, werden wiederum selektiv zu Si₃N₄ und Silizium entfernt. Es liegt im Rahmen der Erfindung, gleichzeitig die SiO₂-Schicht 23 zu entfernen.

Die fertige Grabenstruktur 5 weist senkrechte Seitenwände auf, die bis zu der ersten Tiefe t₁ mit den zweiten Si₃N₄-Spacern 41 bedeckt sind. Die erste Tiefe t₁ ist dabei über die erste Grabenätzung einstellbar. Es liegt im Rahmen der Erfindung, den Prozeß mit einem Oxidationsschritt fortzusetzen, bei dem die freiliegende Oberfläche des Substrats 1 im Bereich der Grabenstruktur 5 mit einer SiO₂-Schicht verseher wird. Dabei wirken die zweiten Si₃N₄-Spacer 41 als Oxidationsmaske.

Für den anisotropen Ätzprozeß zur Erzeugung der zweiten Si₃N₄-Spacer 41 und der zweiten Grabenätzung können im wesentlichen dieselben Parameter wie für die erste Spacer- und Grabenätzung verwendet werden.

## Patentansprüche

1. Verfahren zur Herstellung einer Grabenstruktur in einem Substrat,
- bei dem auf dem Substrat (1) aus einkristallinem Silizium eine Grabenmaske (2) erzeugt wird, die mindestens an der Oberfläche SiO₂ aufweist und die einem Ätzprozeß zur Erzeugung der Grabenstruktur (5) widersteht,
- bei dem an senkrechten Flanken der Grabenmaske (2) durch Abscheiden und anisotropes Rückätzen einer ersten Si₃N₄-Schicht (3) erste Si₃N₄-Spacer (31) erzeugt werden,
- bei dem in einem anisotropen Ätzprozeß selektiv zu SiO₂ eine erste Grabenätzung in das Substrat (1) in einer ersten Tiefe (t₁) vorgenommen wird, wobei sich an Seitenwänden der entstehenden Grabenstruktur (5) oxidartige Passivierungsschichten bilden,
- bei dem die oxidartigen Passivierungsschichten selektiv zu Si₃N₄ und zu Silizium entfernt werden,
- bei dem an senkrechten Flanken der ersten Si₃N₄-Spacer (31) und an den Seitenwänden der entstehenden Grabenstruktur (5) durch Abscheiden und anisotropes Rückätzen einer zweiten Si₃N₄-Schicht (4) zweite Si₃N₄-Spacer (41) gebildet werden,
- bei dem in einem anisotropen Ätzprozeß selektiv zu SiO₂ eine zweite Grabenätzung in einer zweiten Tiefe (t₂) in das Substrat (1) vorgenommen wird, durch die die Grabenstruktur (5) in einer Tiefe entsprechend der Summe aus erster Tiefe (t₁) und zweiter Tiefe (t₂) fertiggestellt wird.

2. Verfahren nach Anspruch 1,
bei dem die Grabenmaske (2) aus einer SiO₂-Schicht (21) auf dem Substrat (1), aus einer Si₃N₄-Schicht (22) auf der SiO₂-Schicht (21) und aus einer durch thermische Zersetzung von Si(OC₂H₅)₄ gebildeten SiO₂-Schicht (23), die eine Dicke im Bereich von 400 nm bis 1000 nm aufweist, hergestellt wird.

3. Verfahren nach Anspruch 1 oder 2,
bei dem die erste Si₃N₄-Schicht (3) und die zweite Si₃N₄-Schicht (4) in einer Dicke im Bereich von 20 nm bis 100 nm abgeschieden werden.

4. Verfahren nach einem der Ansprüche 1 bis 3,
bei dem die erste Tiefe (t₁) der ersten Grabenätzung 0,5 µm bis 3 µm und die zweite Tiefe (t₂) der zweiten Grabenätzung 3 bis 10 µm beträgt.

5. Verfahren nach einem der Ansprüche 1 bis 4,
bei dem die Erzeugung der ersten Si₃N₄-Spacer (31) und die erste Grabenätzung in demselben anisotropen Ätzprozeß erfolgen.

6. Verfahren nach einem der Ansprüche 1 bis 5,
bei dem die Erzeugung der zweiten Si₃N₄-Spacer (41) und die zweite Grabenätzung in demselben anisotropen Ätzprozeß erfolgen.

7. Verfahren nach einem der Ansprüche 1 bis 6,
bei dem bei der zweiten Grabenätzung gebildete oxidartige Passivierungsschichten nach der zweiten Grabenätzung selektiv zu Si₃N₄ und Silizium entfernt werden.

8. Verfahren nach Anspruch 7,
bei dem an der Oberfläche der Grabenstruktur (5) selbstjustiert zu den ersten Si₃N₄-Spacern (31) und den zweiten Si₃N₄-Spacern (41) eine SiO₂-Schicht gebildet wird.

9. Verfahren nach einem der Ansprüche 1 bis 8,
bei dem die oxidartigen Passivierungsschichten durch HF-Dampf oder naßchemisch entfernt werden.

## Claims

1. Method for producing a trench structure in a substrate,
- in which a trench mask (2) is produced on the substrate (1) made of monocrystalline silicon, which mask has SiO₂ at least on the surface and withstands an etching process for producing the trench structure (5),
- in which first Si₃N₄ spacers (31) are produced on vertical edges of the trench mask (2) by deposition and anisotropic etching back of a first Si₃N₄ layer (3),
- in which a first trench is etched into the substrate (1) to a first depth (t₁) selectively with respect to SiO₂ in an anisotropic etching process, oxide-like passivation layers forming on side walls of the resulting trench structure (5),
- in which the oxide-like passivation layers are removed selectively with respect to Si₃N₄ and with respect to silicon,
- in which second Si₃N₄ spacers (41) are formed on vertical edges of the first Si₃N₄ spacers (31) and on the side walls of the resulting trench structure (5) by deposition and anisotropic etching back of a second Si₃N₄ layer (4),
- in which a second trench is etched into the substrate (1) to a second depth (t₂) selectively with respect to SiO₂ in an anisotropic etching process, as a result of which the trench structure (5) is completed to a depth corresponding to the sum of the first depth (t₁) and the second depth (t₂).

2. Method according to Claim 1,
in which the trench mask (2) is produced from an SiO₂ layer (21) on the substrate (1), from an Si₃N₄ layer (22) on the SiO₂ layer (21) and from an SiO₂ layer (23) which is formed by thermal decomposition of Si(OC₂H₅)₄ and has a thickness in the range of 400 nm to 1000 nm.

3. Method according to Claim 1 or 2,
in which the first Si₃N₄ layer (3) and the second Si₃N₄ layer (4) are deposited with a thickness in the range of 20 nm to 100 nm.

4. Method according to one of Claims 1 to 3,
in which the first depth (t₁) of the first trench etching is 0.5 µm to 3 µm and the second depth (t₂) of the second trench etching is 3 to 10 µm.

5. Method according to one of Claims 1 to 4,
in which the production of the first Si₃N₄ spacers (31) and the first trench etching are carried out in the same anisotropic etching process.

6. Method according to one of Claims 1 to 5,
in which the production of the second Si₃N₄ spacers (41) and the second trench etching are carried out in the same anisotropic etching process.

7. Method according to one of Claims 1 to 6,
in which oxide-like passivation layers formed during the second trench etching are removed selectively with respect to Si₃N₄ and silicon after the second trench etching.

8. Method according to Claim 7,
in which an SiO₂ layer is formed on the surface of the trench structure (5) in a manner self-aligned with respect to the first Si₃N₄ spacers (31) and the second Si₃N₄ spacers (41).

9. Method according to one of Claims 1 to 8,
in which the oxide-like passivation layers are removed by HF vapour or by wet-chemical means.

## Revendications

1. Procédé pour la fabrication d'une structure de fossés dans un substrat,
- dans lequel on forme sur le substrat (1) un masque de fossés (2) en silicium monocristallin, qui présente du SiO₂ au moins sur sa surface et qui résiste à un procédé de gravure pour l'obtention de la structure de fossés (5),
- dans lequel, contre les flancs verticaux du masque de fossés (2), par déposition et par gravure anisotrope en retrait d'une première couche (3) de Si₃N₄, on forme des premiers éléments d'écartement (31) en Si₃N₄,
- dans lequel, dans un procédé de gravure anisotrope, de manière sélective par rapport au SiO₂, on procède à une première gravure de fossés dans le substrat (1) à une première profondeur (t₁), des couches de passivation de type oxyde se formant contre les parois latérales de la structure de fossés (5) obtenue,
- dans lequel on élimine les couches de passivation de type oxyde, de manière sélective par rapport au Si₃N₄ et par rapport au silicium,
- dans lequel, contre les flancs verticaux des premiers éléments d'écartement (31) en Si₃N₄ et contre les parois latérales de la structure de fossés (5) obtenue, par déposition et par gravure anisotrope en retrait d'une seconde couche (4) en Si₃N₄, on forme des seconds éléments d'écartement (41) en Si₃N₄,
- dans lequel, dans un procédé de gravure anisotrope, de manière sélective par rapport au SiO₂, on procède à une deuxième gravure de fossés à une seconde profondeur (t₂) dans le substrat (1), par laquelle on réalise la structure de fossés (5) à une profondeur correspondant à la somme de la première profondeur (t₁) et de la seconde profondeur (t₂).

2. Procédé selon la revendication 1, dans lequel on fabrique le masque de fossés (2) constitué par une couche (21) en SiO₂ sur le substrat (1), par une couche (22) en Si₃N₄ sur la couche (21) en SiO₂ et par une couche (23) en SiO₂ qui est formée par décomposition thermique de Si(OC₂H₅)₄, qui présente une épaisseur dans le domaine de 400 nm à 1.000 nm.

3. Procédé selon la revendication 1 ou 2, dans lequel on dépose la première couche (3) en Si₃N₄ et la seconde couche (4) en Si₃N₄ en une épaisseur dans le domaine de 20 nm à 100 nm.

4. Procédé selon l'une quelconque des revendications 1 à 3, dans lequel la première profondeur (t₁) de la première gravure de fossés s'élève de 0,5 µm à 3 µm et la seconde profondeur (t₂) de la seconde gravure de fossés s'élève de 3 à 10 µm.

5. Procédé selon l'une quelconque des revendications 1 à 4, dans lequel la formation des premiers éléments d'écartement (31) en Si₃N₄, ainsi que la première gravure de fossés ont lieu dans le même procédé de gravure anisotrope.

6. Procédé selon l'une quelconque des revendications 1 à 5, dans lequel la formation des seconds éléments d'écartement (41) Si₃N₄ et la seconde gravure de fossés ont lieu dans le même procédé de gravure anisotrope.

7. Procédé selon l'une quelconque des revendications 1 à 6, dans lequel on élimine les couches de passivation de type oxyde formées lors de la seconde gravure de fossés, après la seconde gravure de fossés, de manière sélective par rapport au Si₃N₄ et par rapport au silicium.

8. Procédé selon la revendication 7, dans lequel on forme une couche de SiO₂ à la surface de la structure de fossés (5) qui s'ajuste automatiquement aux premiers éléments d'écartement (31) en Si₃N₄ et aux seconds éléments d'écartement (41) en Si₃N₄.

9. Procédé selon l'une quelconque des revendications 1 à 8, dans lequel on élimine les couches de passivation de type oxyde par vapeur HF ou par un procédé chimique par voie humide.
